# EUROPEAN PATENT APPLICATION

(11) **EP 4 571 752 A1**
(43) Date of publication of application: **18.06.2025**
(21) Application number: 24847898.4
(22) Date of filing: 27.06.2024
(51) Int. Cl.: G11C 11/4096

(54) **READ-WRITE CONVERSION CIRCUIT, WRITE DRIVE CIRCUIT AND MEMORY**

(30) Priority: 03.08.2023 CN 202310973526
(71) Applicant: CXMT Corporation, Hefei City, Anhui Province 230601 (CN)
(72) Inventor: SHANG, Weibing, Hefei, Anhui 230601 (CN); HAN, Xiangyun, Hefei, Anhui 230601 (CN); LUO, Yifei, Hefei, Anhui 230601 (CN); ZHOU, Xinyu, Hefei, Anhui 230601 (CN); WANG, Xindi, Hefei, Anhui 230601 (CN); ZHAO, Shuaipeng, Hefei, Anhui 230601 (CN)
(74) Representative: Gulde & Partner
(86) International application number: PCT/CN2024/102083
(87) International publication number: WO 2025/025937

(57) **Abstract**

The present disclosure provides a read/write conversion circuit, a write driver circuit, and a memory. The read/write conversion circuit includes a read circuit and a write circuit. A first input terminal and a second input terminal of the read circuit are respectively connected to a local signal line and a complementary local signal line, and a first output terminal and a second output terminal thereof are respectively connected to a global signal line and a complementary global signal line. A first input terminal and a second input terminal of the write circuit are respectively connected to the global signal line and the complementary global signal line, and a first output terminal and a second output terminal thereof are respectively connected to the local signal line and the complementary local signal line. The first input terminal and the second input terminal of the write circuit receive the same data, and the first output terminal and the second output terminal of the write circuit output inverted data.

## Description

### CROSS-REFERENCE TO RELATED APPLICATIONS

This application claims priority to Chinese Patent Application No. 202310973526.7, filed with the China National Intellectual Property Administration on August 3, 2023 and entitled "READ/WRITE CONVERSION CIRCUIT, WRITE DRIVER CIRCUIT, AND MEMORY", which is incorporated herein by reference in its entirety.

### TECHNICAL FIELD

The present disclosure relates to the field of memory technologies, and specifically, to a read/write conversion circuit, a write driver circuit, and a memory capable of increasing a read/write speed.

### BACKGROUND

In DRAM memories, a data read/write path is mainly constituted by a read/write control circuit, a read/write conversion circuit, and a sense amplifier.

During data write, data sent by a controller is received by a write driver circuit in a read/write control circuit, and data to be written is sent to a read/write conversion circuit. Then, the data is transmitted by the read/write conversion circuit to a sense amplifier, amplified by a sense amplification function of the sense amplifier, and written to a storage cell. During data read, a sense amplifier is run to amplify data stored in a storage cell. Then, the data is transmitted to a read/write conversion circuit, and further transmitted by the read/write conversion circuit to a read buffer circuit in a read/write control circuit.

In related technologies, a read/write conversion circuit is generally set to operate in a differential double-ended operating mode (complementary data is transmitted over two signal lines) or a single-polarity transmission mode (data is transmitted over one signal line). The differential double-ended work mode is subject to high power, whereas the single-polarity transmission mode is susceptible to noise interference. Therefore, it is difficult for a read/write conversion circuit to achieve a balance between performance and power consumption.

It should be noted that the information disclosed in the background part is only for enhancing understanding of the background of the present disclosure, and therefore may include information not constituting the prior art known to a person of ordinary skill in the art.

### SUMMARY

The present disclosure aims to provide a read/write conversion circuit, a write driver circuit, and a memory, so as to increase a read/write speed of the read/write conversion circuit and decrease read/write power consumption.

According to a first aspect of the present disclosure, a read/write conversion circuit is provided, including: a first read circuit and a first write circuit. A first input terminal and a second input terminal of the first read circuit are respectively connected to a local signal line and a complementary local signal line. A first output terminal and a second output terminal of the first read circuit are respectively connected to a global signal line and a complementary global signal line. A first input terminal and a second input terminal of the first write circuit are respectively connected to the global signal line and the complementary global signal line. A first output terminal and a second output terminal of the first write circuit are respectively connected to the local signal line and the complementary local signal line. The first input terminal and the second input terminal of the first write circuit receive the same data, and the first output terminal and the second output terminal of the first write circuit output inverted data.

In an example embodiment of the present disclosure, the first write circuit includes a first write conversion circuit connected between the first input terminal and the first output terminal of the first write circuit and a second write conversion circuit connected between the second input terminal and the second output terminal of the first write circuit, the first write conversion circuit is configured to transmit data from the global signal line to the local signal line, and the second write conversion circuit is configured to transmit inverted data, of the data, from the complementary global signal line to the complementary local signal line.

In an example embodiment of the present disclosure, the first write conversion circuit includes a first write transistor, a first terminal of the first write transistor is connected to the global signal line, a second terminal of the first write transistor is connected to the local signal line, and a control terminal of the first write transistor receives a write control signal; the second write conversion circuit includes a second write transistor and a third write transistor, a first terminal of the second write transistor is grounded, a control terminal thereof is connected to the complementary global signal line, a first terminal of the third write transistor is connected to a second terminal of the second write transistor, a second terminal of the third write transistor is connected to the complementary local signal line, and a control terminal of the third write transistor receives the write control signal; and the first write transistor, the second write transistor, and the third write transistor are all N-type transistors.

In an example embodiment of the present disclosure, the first read circuit includes a first read conversion circuit connected between the first input terminal and the first output terminal of the first read circuit, a second read conversion circuit connected between the second input terminal and the second output terminal of the first read circuit, and a voltage source circuit connecting the first read conversion circuit and the second read conversion circuit, the first read conversion circuit and the second read conversion circuit have the same structure, the first read circuit is configured to transmit data from the local signal line to the global signal line, and the second read circuit is configured to transmit data from the complementary local signal line to the complementary global signal line.

In an example embodiment of the present disclosure, the first read conversion circuit includes a first read transistor and a second read transistor, a control terminal of the first read transistor is connected to the local signal line, a first terminal of the first read transistor is connected to the voltage source circuit, a control terminal of the second read transistor receives a read control signal, a first terminal of the second read transistor is connected to a second terminal of the first read transistor, and a second terminal of the second read transistor is connected to the global signal line; the second read conversion circuit includes a third read transistor and a fourth read transistor, a control terminal of the third read transistor is connected to the complementary local signal line, a first terminal of the third read transistor is connected to the voltage source circuit, a control terminal of the fourth read transistor receives a read control signal, a first terminal of the fourth read transistor is connected to a second terminal of the third read transistor, and a second terminal of the fourth read transistor is connected to the complementary global signal line; and the first read transistor, the second read transistor, the third read transistor, and the fourth read transistor are all N-type transistors.

According to a second aspect of the present disclosure, a write driver circuit is provided, and is connected to the read/write conversion circuit according to any one of the foregoing embodiments, including: a first write driver unit and a second write driver unit. Input terminals of the first write driver unit and the second write driver unit are configured to receive the same external input data. An output terminal of the first write driver unit is connected to a global signal line. An output terminal of the second write driver unit is connected to a complementary global signal line. Output data of the first write driver unit and the second write driver unit is the same.

According to a third aspect of the present disclosure, a read/write conversion circuit is provided, including: a second read circuit, a second write circuit, and a local read/write control circuit. The second read circuit includes a first input terminal, a second input terminal, a first output terminal, and a second output terminal, the first input terminal and the second input terminal of the second read circuit are respectively connected to a local signal line and a complementary local signal line, and the first output terminal and the second output terminal of the second read circuit are respectively connected to a global signal line and a complementary global signal line. The second write circuit includes a first input terminal, a second input terminal, a first output terminal, and a second output terminal, the first input terminal and the second input terminal of the second write circuit are respectively connected to the global signal line and the complementary global signal line, and the first output terminal and the second output terminal of the second write circuit are respectively connected to the local signal line and the complementary local signal line. The local read/write control circuit includes a first input terminal, a second input terminal, a first output terminal, and a second output terminal, the first input terminal and the second input terminal of the local read/write control circuit are respectively connected to the local signal line and the complementary local signal line, and the first output terminal and the second output terminal of the local read/write control circuit are respectively connected to a bit line and a complementary bit line. The first input terminal and the second input terminal of the second write circuit receive inverted data, and the first output terminal and the second output terminal of the second write circuit output the same data. The first input terminal and the second input terminal of the local read/write control circuit receive the same data, and the first output terminal and the second output terminal of the local read/write control circuit output inverted data.

In an example embodiment of the present disclosure, the second read circuit includes a third read conversion module and a fourth read conversion module. The third read conversion module is connected between the global signal line and the local signal line, and is configured to transmit data on the local signal line to the global signal line. The fourth read conversion module is connected between the complementary global signal line and the complementary local signal line, and is configured to transmit data on the complementary local signal line to the complementary global signal line. The second write circuit includes a third write conversion circuit connected between the global signal line and the local signal line and a fourth write conversion circuit connected between the complementary global signal line and the complementary local signal line. The third write conversion circuit is configured to transmit data on the global signal line to the local signal line during a write operation. The fourth write conversion circuit is configured to transmit data on the complementary global signal line to the complementary local signal line during a write operation. The local read/write control circuit includes a first read/write control circuit connected between the local signal line and the bit line and a second read/write control circuit connected between the complementary local signal line and the complementary bit line. The first read/write control circuit is configured to transmit data on the local signal line to the bit line during a write operation, and transmit data on the bit line to the local signal line during a read operation. The second read/write control circuit is configured to transmit data on the complementary local signal line to the complementary bit line during a write operation and transmit data on the complementary bit line to the complementary local signal line during a read operation.

In an example embodiment of the present disclosure, the third write conversion circuit includes a first write transistor, a first terminal of the first write transistor is connected to the global signal line, a second terminal thereof is connected to the local signal line, and a control terminal thereof receives a write control signal; and the fourth write conversion circuit includes a data inverter and a third write transistor, an input terminal of the data inverter is connected to the complementary global signal line, an output terminal thereof is connected to a first terminal of the third write transistor, a second terminal of the third write transistor is connected to the complementary local signal line, and a control terminal thereof receives a write control signal.

In an example embodiment of the present disclosure, the first read/write control circuit includes a sixth read transistor, a fourth write transistor, a fifth write transistor, and a first column selection transistor; a first terminal of the sixth read transistor is connected to the local signal line, a second terminal thereof is connected to a first terminal of the first column selection transistor, and a control terminal thereof receives a read control signal; a gate of the fourth write transistor is connected to the local signal line, a source thereof is grounded, and a drain thereof is connected to a second terminal of the fifth write transistor; a first terminal of the fifth write transistor is connected to the first terminal of the first column selection transistor, and a control terminal thereof receives a write control signal; a second terminal of the first column selection transistor is connected to the bit line, and a control terminal thereof receives a column selection signal; and the second read/write control circuit includes a second column selection transistor, a first terminal of the second column selection transistor is connected to the complementary local signal line, a second terminal thereof is connected to the complementary bit line, and a control terminal thereof receives a column selection signal.

According to a fourth aspect of the present disclosure, a memory is provided, including the circuit according to any one of the foregoing embodiments.

In the embodiments of the present disclosure, the read/write conversion circuit is set to utilize a differential double-ended work mode during a read operation, and utilize two data lines to transmit the same data during a write operation. As such, an anti-noise capability in a read operation process can be improved, a read speed can be increased, and power consumption of a write operation can be decreased. In addition, a conversion speed for converting a write operation to a read operation can be increased, thereby improving overall performance of the memory.

It should be understood that the foregoing general descriptions and the following detailed descriptions are merely examples and explanations, and are not intended to limit the present disclosure.

### BRIEF DESCRIPTION OF DRAWINGS

The accompanying drawings herein, which are incorporated in and constitute a part of this specification, illustrate embodiments conforming to the present disclosure, and are utilized together with this specification to explain the principles of the present disclosure. Clearly, the accompanying drawings in the following descriptions show merely some embodiments of the present disclosure, and a person of ordinary skill in the art may still derive other drawings from these accompanying drawings without creative efforts.
FIG. 1 is a schematic structural diagram of a read/write conversion circuit according to an example embodiment of the present disclosure;
FIG. 2 is a schematic diagram of a read/write conversion circuit according to an embodiment of the present disclosure;
FIG. 3 is a circuit diagram of a first write circuit according to an embodiment of the present disclosure;
FIG. 4 is a circuit diagram of a second read circuit according to an embodiment of the present disclosure;
FIG. 5A to FIG. 5D are schematic diagrams of a circuit with a local signal line LIO connected to a complementary local signal line LIO# according to an embodiment of the present disclosure;
FIG. 6 is a schematic diagram of a read/write conversion circuit according to an embodiment of the present disclosure;
FIG. 7 is a schematic diagram of a write driver circuit according to an embodiment of the present disclosure;
FIG. 8 is a schematic diagram of another read/write conversion circuit according to an example embodiment of the present disclosure; and
FIG. 9 is a circuit diagram of a read/write conversion circuit 800 according to an embodiment.

### DESCRIPTION OF EMBODIMENTS

Now, example implementations are further comprehensively described with reference to the accompanying drawings. However, the example implementations can be implemented in multiple forms and should not be construed as a limitation to the examples described herein. Instead, these implementations are provided to make the present disclosure more comprehensive and complete, and the concept of the example implementations is comprehensively conveyed to a person skilled in the art. The described features, structures, or characteristics may be combined in one or more implementations in any suitable manner. In the following description, many specific details are provided to give a full understanding of the implementations of the present disclosure. However, a person skilled in the art will realize that one or more of the specific details may be omitted by practicing the technical solutions of the present disclosure, or another method, component, apparatus, step, or the like may be utilized. In other cases, well-known technical solutions are not detailed or described to avoid overshadowing the aspects of the present disclosure and to prevent any ambiguity.

In addition, the accompanying drawings are merely schematic diagrams of the present disclosure, and the same reference numerals in the figure represent the same or similar parts, and therefore, repeated descriptions thereof are omitted. Some block diagrams shown in the accompanying drawings are functional entities and may not necessarily correspond to physically or logically independent entities. These functional entities may be implemented in a form of software, or these functional entities are implemented in one or more hardware modules or integrated circuits, or these functional entities are implemented in different networks and/or processor apparatuses and/or microcontroller apparatuses.

The following describes in detail example implementations of the present disclosure with reference to the accompanying drawings.

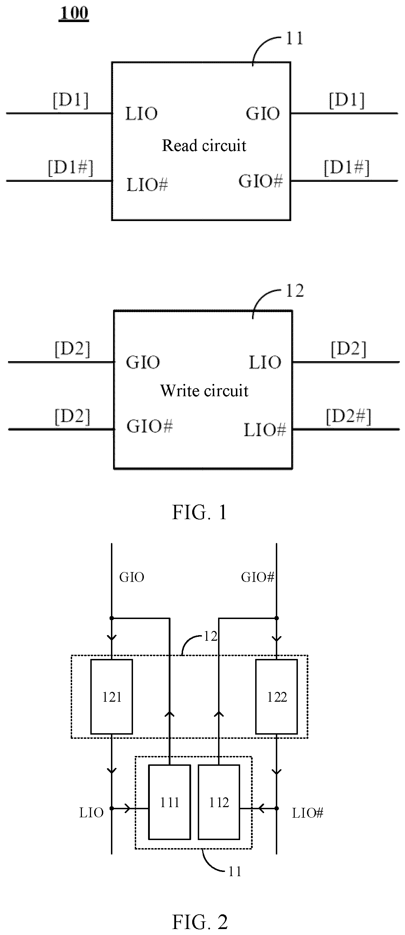

FIG. 1 is a schematic structural diagram of a read/write conversion circuit according to an example embodiment of the present disclosure.

Referring to FIG. 1, a read/write conversion circuit 100 may include the following:
a first read circuit 11, a first input terminal and a second input terminal of the first read circuit 11 being respectively connected to a local signal line LIO and a complementary local signal line LIO#, and a first output terminal and a second output terminal of the first read circuit 11 being respectively connected to a global signal line GIO and a complementary global signal line GIO#; and
a first write circuit 12, a first input terminal and a second input terminal of the first write circuit 12 being respectively connected to the global signal line GIO and the complementary global signal line GIO#, and a first output terminal and a second output terminal of the first write circuit 12 being respectively connected to the local signal line LIO and the complementary local signal line LIO#;
the first input terminal and the second input terminal of the first write circuit 12 receiving the same data, and the first output terminal and the second output terminal of the first write circuit 12 outputting inverted data.

In some conventional technologies, the read/write conversion circuit operates in a double-ended differential operating mode. The local signal line LIO and the complementary local signal line LIO# simultaneously transmit complementary data with inverted phases, and the global signal line GIO and the complementary global signal line GIO# simultaneously transmit complementary data with inverted phases, thereby helping eliminate common mode noise, enabling a sense amplifier to identify and amplify a relatively small difference between signals, and helping improving signal transmission performance. However, in a data write process, data on the global signal line GIO and the complementary global signal line GIO# needs to be frequently toggled based on input data, and consequently power consumption is high.

In some other conventional technologies, the read/write conversion circuit operates in a single-polarity operating mode. Data is transmitted only through the local signal line LIO and the global signal line GIO. No complementary global signal line GIO# is provided, or data is not transmitted through the complementary global signal line GIO#, but a single unpaired data line (without a complementary data line) is used for data transmission. During a write operation, a toggle frequency for signal transmission on the global signal line GIO can be reduced and power consumption can be decreased, but a noise suppression capability is poor and a signal is susceptible to noise interference.

In this embodiment of the present disclosure, the first input terminal and the second input terminal of the first write circuit 12 receive the same second data D2 respectively through the global signal line GIO and the complementary global signal line GIO#, and output the second data D2 and inverted data D2# of the second data D2 to the local signal line LIO and the complementary local signal line LIO# through the first output terminal and the second output terminal.

During a write operation, the first write circuit 12 operates in the single-polarity work mode, that is, simultaneously transmits data of the same polarity through two signal lines, so as to reduce toggle frequencies of the data transmission lines. The layout and wiring of the global signal line GIO and the complementary global signal line GIO# may be adjusted in a coordinated manner. This increases a write speed and decreases write power consumption. For example, if the global signal line GIO and the complementary global signal line GIO# are directly laid out adjacent to each other, due to the same data, the global signal line GIO and the complementary global signal line GIO# are free from crosstalk and feature low power consumption and a high data transmission speed.

In addition, as the global signal line GIO and the complementary global signal line GIO# transmit signals of the same phase in a write operation, during conversion from the write operation to a read operation, a speed for implementing a pre-equalization operation (setting the global signal line GIO and the complementary global signal line GIO# to the same potential) in the first stage is relatively fast, that is, a speed for converting the write operation into a read operation is relatively fast, and read/write efficiency is further improved.

FIG. 2 is a schematic diagram of a read/write conversion circuit according to an embodiment of the present disclosure.

Referring to FIG. 2, in an embodiment, the first read circuit 11 includes a first read conversion circuit 111 connected between the first input terminal and the first output terminal of the read circuit 11 and a second read conversion circuit 112 connected between the second input terminal and the second output terminal of the read circuit 11. As defined by a function of the first read circuit 11, the first read conversion circuit 111 and the second read conversion circuit 112 have the same circuit function.

The first write circuit 12 includes a first write conversion circuit 121 connected between the first input terminal and the first output terminal of the first write circuit 12 and a second write conversion circuit 122 connected between the second input terminal and the second output terminal of the first write circuit 12. The first write conversion circuit 121 is configured to transmit input data, and the second write conversion circuit 122 is configured to invert and output the input data.

Disposing the two read conversion circuits with the same function allows the first read circuit 11 to operate in the double-ended differential mode, thereby increasing a data transmission rate. Compared with operating in the single-polarity transmission mode, operating in the double-ended differential mode features a higher transmission speed and higher reliability.

Disposing the two write conversion circuits receiving the same data and sending inverted data allows the first write circuit 12 to receive the same data. When the data is toggled, toggle states are consistent, thereby achieving a higher data toggle speed. This helps reduce power consumption caused by repeated data toggles, and increases a data transmission speed.

Therefore, a balance between a high data transmission speed and low power consumption is implemented.

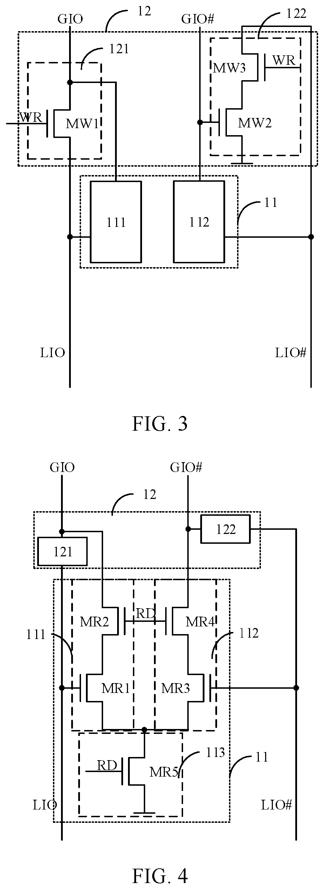

FIG. 3 is a circuit diagram of a first write circuit according to an embodiment of the present disclosure.

Referring to FIG. 3, in an embodiment, the first write conversion circuit 121 includes a first write transistor MW1. A first terminal of the first write transistor MW1 is connected to the global signal line GIO, a second terminal of the first write transistor MW1 is connected to the local signal line LIO, and a control terminal of the first write transistor MW1 receives a write control signal WR.

The second write conversion circuit 122 includes a second write transistor MW2 and a third write transistor MW3, a first terminal of the second write transistor MW2 is grounded, a control terminal thereof is connected to the complementary global signal line GIO#, a first terminal of the third write transistor MW3 is connected to a second terminal of the second write transistor MW2, a second terminal of the third write transistor MW3 is connected to the complementary local signal line LIO#, and a control terminal of the third write transistor MW3 receives the write control signal WR.

The first write transistor MW1, the second write transistor MW2, and the third write transistor MW3 are all N-type transistors. An amplification circuit is connected between the local signal line LIO and the complementary local signal line LIO#. Before data is written, the local signal line LIO and the complementary local signal line LIO# are pre-equalized to a first equalization voltage (the first equalization voltage may be greater than a bit line equalization voltage, for example, the first equalization voltage is 1.05 V, and the bit line equalization voltage is 0.5 V). After a write operation starts, when a voltage difference occurs between the local signal line LIO and the complementary local signal line LIO#, the amplification circuit connected between the local signal line LIO and the complementary local signal line LIO# amplifies voltages of the local signal line LIO and the complementary local signal line LIO# to a source voltage VDD and a ground voltage VSS, respectively, to represent data 1 and data 0.

In the embodiment shown in FIG. 3, during a write operation, the write control signal WR is at a high level (enabled state), both the first write transistor MW1 and the third write transistor MW3 are in an on state, the global signal line GIO is connected to the local signal line LIO through the turned-on first write transistor MW1, and the complementary global signal line GIO# and the complementary local signal line LIO# are respectively connected to a gate and a drain of the second write transistor MW2.

When both the global signal line GIO and the complementary global signal line GIO# transmit the data 1, the local signal line LIO transmits the data 1, the second write transistor MW2 is turned on, the complementary local signal line LIO# receives a low-level signal through the second write transistor MW2, and the complementary local signal line LIO# transmits the data 0.

When both the global signal line GIO and the complementary global signal line GIO# transmit the data 0, the local signal line LIO transmits the data 0, the second write transistor MW2 is turned off, the complementary local signal line LIO# maintains the first equalization voltage representing a high level, the amplification circuit connected between the local signal line LIO and the complementary local signal line LIO# amplifies the voltages of the local signal line LIO and the complementary local signal line LIO# to the ground voltage VSS and the source voltage VDD, respectively, to represent the data 0 and the data 1.

The complementary global signal line GIO# sets the data 1 faster for the complementary local signal line LIO# (a default state of the complementary local signal line LIO# is the first equalization voltage) and sets the data 0 slower (because the voltage needs to be adjusted and an adjustment process is subject to switching speeds and driver capabilities of the second write transistor MW2 and the third write transistor MW3).

FIG. 3 is merely an example of a manner of inverting data transmitted on the complementary global signal line GIO#. In another embodiment, alternatively, the second write transistor MW2 may be directly replaced with an inverter. An input terminal of the inverter is connected to the complementary global signal line GIO#, and an output terminal of the inverter is connected to a source of the third write transistor MW3. Therefore, when the write control signal WR is at a high level (enabled state) and both the first write transistor MW1 and the third write transistor MW3 are in an on state, data on the complementary local signal line LIO# is always inverted data (complementary data) of the complementary global signal line GIO#.

Regardless of a specific embodiment, a transistor with turn-on controlled by the write control signal WR is disposed on both the global signal line GIO and the complementary global signal line GIO#, to prevent the global signal line GIO and the complementary global signal line GIO# from transmitting data to the local signal line LIO and the complementary local signal line LIO# during a non-write operation.

A person skilled in the art may autonomously dispose specific circuits for the first write conversion circuit 121 and the second write conversion circuit 122 based on defined functions of the first write conversion circuit 121 and the second write conversion circuit 122. No special limitation is imposed on the present disclosure.

FIG. 4 is a circuit diagram of a first read circuit according to an embodiment of the present disclosure.

Referring to FIG. 4, in an embodiment, the first read conversion circuit 111 includes a first read transistor MR1 and a second read transistor MR2. A control terminal of the first read transistor MR1 is connected to the local signal line LIO, a first terminal of the first read transistor MR1 is connected to a voltage source circuit 113, a control terminal of the second read transistor MR2 receives a read control signal RD, a first terminal of the second read transistor MR2 is connected to a second terminal of the first read transistor MR1, and a second terminal of the second read transistor MR2 is connected to the global signal line GIO.

The second read conversion circuit 112 includes a third read transistor MR3 and a fourth read transistor MR4, a control terminal of the third read transistor MR3 is connected to the complementary local signal line LIO#, a first terminal of the third read transistor MR3 is connected to the voltage source circuit 113, a control terminal of the fourth read transistor MR4 receives a read control signal RD, a first terminal of the fourth read transistor MR4 is connected to a second terminal of the third read transistor MR3, and a second terminal of the fourth read transistor MR4 is connected to the complementary global signal line GIO#.

The first read transistor MR1, the second read transistor MR2, the third read transistor MR3, and the fourth read transistor MR4 are all N-type transistors.

The voltage source circuit 113 includes a fifth read transistor MR5, a first terminal of the fifth read transistor MR5 is grounded, a second terminal thereof is connected to the first read conversion circuit 111 and the second read conversion circuit 112, and a control terminal thereof receives the read control signal RD.

During a read operation, the read control signal RD is at a high level (enabled state), the second read transistor MR2, the fourth read transistor MR4, and the fifth read transistor MR5 are all in the on state. A gate of the first read transistor MR1 is connected to the local signal line LIO, a source thereof is grounded, and a drain thereof is connected to the global signal line GIO; and a gate of the third read transistor MR3 is connected to the complementary local signal line LIO#, a source thereof is grounded, and a drain thereof is connected to the complementary global signal line GIO#.

An amplification circuit is connected between the global signal line GIO and the complementary global signal line GIO#. Before data reading, both the global signal line GIO and the complementary global signal line GIO# are set to a second equalization voltage. After the data reading starts, when a voltage difference occurs between the global signal line GIO and the complementary global signal line GIO#, the amplification circuit connected between the global signal line GIO and the complementary global signal line GIO# amplifies voltages of the global signal line GIO and the complementary global signal line GIO# to the source voltage VDD and the ground voltage VSS, to represent the data 1 and the data 0.

When the local signal line LIO transmits the data 1, the complementary local signal line LIO# transmits the data 0. The first read transistor MR1 is turned on, and the global signal line GIO receives a low-level signal through the turned-on first read transistor MR1. The third read transistor MR3 is turned off, the complementary global signal line GIO# maintains the second equalization voltage, and the amplification circuit connected between the global signal line GIO and the complementary global signal line GIO# amplifies the voltages of the global signal line GIO and the complementary global signal line GIO# to the ground voltage VSS and the source voltage VDD, to represent the data 0 and the data 1.

When the local signal line LIO transmits the data 0, the complementary local signal line LIO# transmits the data 1. The first read transistor MR1 is turned off, and the global signal line GIO maintains the second equalization voltage; and the third read transistor MR3 is turned on, and the complementary global signal line GIO# receives a low-level signal through the turned-on third read transistor MR3. The amplification circuit connected between the global signal line GIO and the complementary global signal line GIO# amplifies the voltages of the global signal line GIO and the complementary global signal line GIO# to the source voltage VDD and the ground voltage VSS, to represent the data 1 and the data 0.

It should be noted that, the second equalization voltage may be at a high potential utilized to represent the data 1, or may be a low-potential state utilized to represent the data 0. In addition, in a read process, data transmitted by the GIO is inverted relative to data transmitted by the LIO. Therefore, the data on the global signal line GIO and the complementary global signal line GIO# needs to be inverted subsequently to ensure that data finally read out is correct.

In another embodiment, the first read circuit 11 may alternatively be disposed in another form. For example, only the first read conversion circuit 111 and the second read conversion circuit 112 are disposed, so that terminals of the first read conversion circuit 111 and the second read conversion circuit 112 originally configured to connect the voltage source circuit 113 are directly grounded. In addition, only the second read transistor MR2 is disposed in the first read conversion circuit 111, and only the fourth read transistor MR4 is disposed in the second read conversion circuit 112. As such, when the second read transistor MR2 and the fourth read transistor MR4 are turned on under control by the read control signal RD, the local signal line LIO and the complementary local signal line LIO# directly transmit data to the global signal line GIO and the complementary signal line GIO#, respectively.

Regardless of a specific embodiment, a transistor with turn-on controlled by the read control signal RD is disposed on both the global signal line GIO and the complementary global signal line GIO#, to prevent the local signal line LIO and the complementary local signal line LIO# from transmitting data to the global signal line GIO and the complementary global signal line GIO# during a non-read operation.

The following describes the amplification circuit connected between the local signal line LIO and the complementary local signal line LIO# and the amplification circuit connected between the global signal line GIO and the complementary global signal line GIO#.

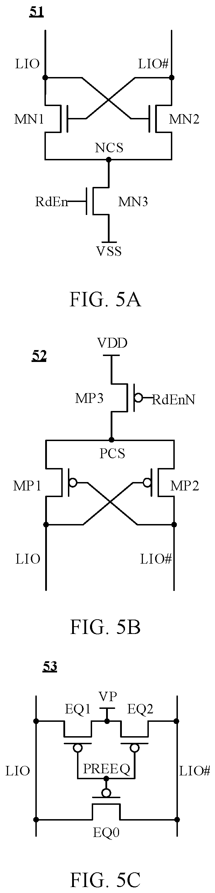

FIG. 5A to FIG. 5D are schematic diagrams of a circuit with a local signal line LIO connected to a complementary local signal line LIO# according to an embodiment of the present disclosure.

Referring to FIG. 5A to FIG. 5C, both the local signal line LIO and the complementary local signal line LIO# are connected to a first amplification circuit 51 and a second amplification circuit 52, and both the first amplification circuit 51 and the second amplification circuit 52 are configured to amplify a voltage difference between the local signal line LIO and the complementary local signal line LIO#.

In addition, an equalization control circuit 53 is connected between the local signal line LIO and the complementary local signal line LIO#. The equalization control circuit 53 is configured to control potentials of both the local signal line LIO and the complementary local signal line LIO# to be equal to a first equalization voltage VP before data reading.

Referring to FIG. 5A, the first amplification circuit 51 includes a first N-type transistor MN1, a second N-type transistor MN2, and a ground control transistor MN3. A first terminal of the first N-type transistor MN1 is connected to the local signal line LIO, a second terminal thereof is connected to a first node NCS, and a control terminal thereof is connected to the complementary local signal line LIO#. A first terminal of the second N-type transistor MN2 is connected to the complementary local signal line LIO#, a second terminal thereof is connected to the first node NCS, and a control terminal thereof is connected to the local signal line LIO. A first terminal of the ground control transistor MN3 is grounded, a second terminal thereof is connected to the first node NCS, and a control terminal thereof receives a read enable signal RdEn. The read enable signal RdEn may be the same as the read control signal RD, or may be slightly earlier than the read control signal RD.

Referring to FIG. 5B, the second amplification circuit 52 includes a first P-type transistor MP1, a second P-type transistor MP2, and a power control transistor MP3. A first terminal of the first P-type transistor MP1 is connected to the local signal line LIO, a second terminal thereof is connected to a second node PCS, and a control terminal thereof is connected to the complementary local signal line LIO#. A first terminal of the second P-type transistor MP2 is connected to the complementary local signal line LIO#, a second terminal thereof is connected to the second node PCS, and a control terminal thereof is connected to the local signal line LIO. A first terminal of the power control transistor MP3 is connected to a source voltage VDD, a second terminal thereof is connected to the second node PCS, a control terminal thereof receives a complementary read enable signal RdEnN. The complementary read enable signal RdEnN is an inverted signal of the read enable signal RdEn.

Referring to FIG. 5C, both the local signal line LIO and the complementary local signal line LIO# are connected to the equalization control circuit 53. The equalization control circuit 53 includes a pre-equalization transistor EQ0, a first equalization transistor EQ1, and a second equalization transistor EQ2. A first terminal and a second terminal of the pre-equalization transistor EQ0 are respectively connected to the local signal line LIO and the complementary local signal line LIO#, and a control terminal thereof receives a pre-equalization signal PREEQ. A first terminal of the first equalization transistor EQ1 is connected to the local signal line LIO, a second terminal thereof is connected to the first equalization voltage VP, and a control terminal thereof receives the pre-equalization signal PREEQ. A first terminal of the second equalization transistor EQ2 is connected to the complementary local signal line LIO#, a second terminal thereof is connected to the first equalization voltage VP, and a control terminal thereof receives the pre-equalization signal PREEQ.

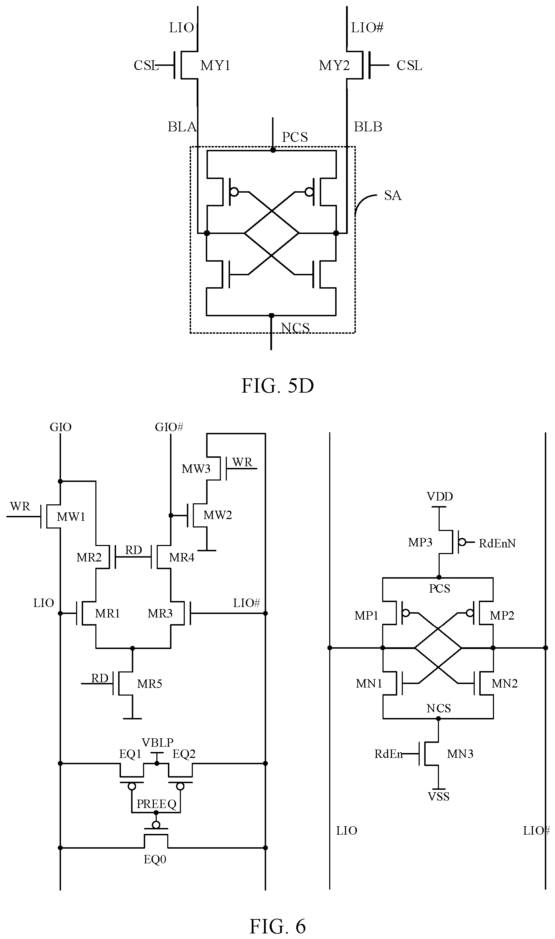

Referring to FIG. 5D, the local signal line LIO is connected to a bit line BLA through a first column selection transistor MY1, and a control terminal of the first column selection transistor MY1 receives a column selection signal CSL. The complementary local signal line LIO# is connected to a complementary bit line BLB through a second column selection transistor MY2, and a control terminal of the second column selection transistor MY2 receives a column selection signal CSL. Both the bit line BLA and the complementary bit line BLB are connected to a sense amplifier SA and a storage cell (not shown).

The first amplification circuit 51, the second amplification circuit 52, and the equalization control circuit 53 may be disposed close to each other, or may be disposed in different locations, provided that a group of the local signal line LIO and the complementary local signal line LIO# are both connected to the first amplification circuit 51, the second amplification circuit 52, and the equalization control circuit 53.

Before data reading, voltages of the bit line BLA and the complementary bit line BLB are controlled to be equal to a bit line equalization voltage. In the equalization control circuit 53, the pre-equalization signal PREEQ controls the pre-equalization transistor EQ0, the first equalization transistor EQ1, and the second equalization transistor EQ2 to be turned on, so that voltages of both the local signal line LIO and the complementary local signal line LIO# are equal to the first equalization voltage VP.

When data reading starts, a transistor in a storage cell is turned on, and charge is exchanged between a storage capacitor in the storage cell and the bit line BLA or the complementary bit line BLB, so that a voltage difference occurs between the bit line BLA and the complementary bit line BLB. The voltage difference is amplified by the sense amplifier SA, so that a higher voltage between the bit line BLA and the complementary bit line BLB is amplified to the source voltage VDD, and a lower voltage is amplified to the ground voltage VSS, to represent the data 1 and the data 0.

Subsequently, the column selection signal CSL controls the bit line BLA and the complementary bit line BLB to transmit data to the local signal line LIO and the complementary local signal line LIO#, respectively, so that a voltage difference occurs between the local signal line LIO and the complementary local signal line LIO#.

When the local signal line LIO transmits the data 1 and the complementary local signal line LIO# transmits the data 0, a potential of the local signal line LIO is higher than that of the complementary local signal line LIO#. Both the power control transistor MP3 and the ground control transistor MN3 are turned on. The second N-type transistor MN2 and the first P-type transistor MP1 are preferentially turned on. The local signal line LIO is set to be connected to the source voltage VDD and the complementary local signal line LIO# is set to be grounded. In addition, the first N-type transistor MN1 and the second P-type transistor MP2 are turned off, so that a potential of the local signal line LIO is equal to the source voltage VDD, and a potential of the complementary local signal line LIO# is equal to the ground voltage VSS.

When the local signal line LIO transmits the data 0 and the complementary local signal line LIO# transmits the data 1, a potential of the local signal line LIO is lower than that of the complementary local signal line LIO#. Both the power control transistor MP3 and the ground control transistor MN3 are turned on. The first N-type transistor MN1 and the second P-type transistor MP2 are preferentially turned on. The local signal line LIO is set to be grounded, and the complementary local signal line LIO# is set to be connected to the source voltage VDD. In addition, the second N-type transistor MN2 and the first P-type transistor MP1 are turned off, so that a potential of the local signal line LIO is equal to the ground voltage VSS, and that of the complementary local signal line LIO# is equal to the source voltage VDD.

Before data writing, in the equalization control circuit 53, the pre-equalization signal PREEQ controls the pre-equalization transistor EQ0, the first equalization transistor EQ1, and the second equalization transistor EQ2 to be turned on, so that both the local signal line LIO and the complementary local signal line LIO# are equal to the first equalization voltage VP.

During a data write operation, the global signal line GIO and the complementary global signal line GIO# transmit data to the local signal line LIO and the complementary local signal line LIO# respectively through the first write conversion circuit 121 and the second write conversion circuit 122, so that a voltage difference occurs between the local signal line LIO and the complementary local signal line LIO#. According to the foregoing principle, the first amplification circuit 51 and the second amplification circuit 52 amplify the voltage difference between the local signal line LIO and the complementary local signal line LIO#, so that a higher voltage between the local signal line LIO and the complementary local signal line LIO# is amplified to the source voltage VDD, and a lower voltage is amplified to the ground voltage VSS, to represent the data 1 and the data 0.

An amplification circuit is also connected between the global signal line GIO and the complementary global signal line GIO# to amplify a voltage difference between the global signal line GIO and the complementary global signal line GIO#, so that a higher voltage between the global signal line GIO and the complementary global signal line GIO# is amplified to the source voltage VDD, and a lower voltage is amplified to the ground voltage VSS, to represent the data 1 and the data 0.

An operating principle of a circuit connected between the global signal line GIO and the complementary global signal line GIO# is the same as a circuit (including the first amplification circuit 51, the second amplification circuit 52, and the equalization control circuit 53) connected between the local signal line LIO and the complementary local signal line LIO#. Details are omitted herein for simplicity.

FIG. 6 is a schematic diagram of a read/write conversion circuit according to an embodiment of the present disclosure.

Referring to FIG. 6, a circuit diagram shown in FIG. 6 is formed with reference to the embodiments of FIG. 3, FIG. 4, and FIG. 5A to FIG. 5C.

During a write operation, when both the global signal line GIO and the complementary global signal line GIO# transmit the data 1, the local signal line LIO and the complementary local signal line LIO# respectively receive the data 1 and the data 0. When both the global signal line GIO and the complementary global signal line GIO# transmit the data 0, the local signal line LIO receives the data 0, while the complementary local signal line LIO# still maintains the first equalization voltage VP, to represent that data on the complementary local signal line LIO# is equal to the data 1.

During a read operation, when the local signal line LIO and the complementary local signal line LIO# respectively transmit the data 1 and the data 0, the first read transistor MR1, the second read transistor MR2, and the fifth read transistor MR5 are turned on, and the global signal line GIO receives a low-level signal. The complementary global signal line GIO# still maintains the second equalization voltage, so that a voltage of the global signal line GIO is lower than the voltage of the complementary global signal line GIO#. The voltage difference is amplified by the amplification circuit connected between the global signal line GIO and the complementary global signal line GIO#, and the complementary global signal line GIO# is set to be connected to the source voltage VDD, so that the complementary global signal line GIO# receives the data 1.

When the local signal line LIO and the complementary local signal line LIO# respectively transmit the data 0 and the data 1, the third read transistor MR3, the fourth read transistor MR4, and the fifth read transistor MR5 are turned on, and the complementary global signal line GIO# receives the data 0. The global signal line GIO still maintains the second equalization voltage, so that a voltage of the global signal line GIO is higher than a voltage of the complementary global signal line GIO#. The voltage difference is amplified by the amplification circuit connected between the global signal line GIO and the complementary global signal line GIO#, and the global signal line GIO is set to be connected to the source voltage VDD, so that the global signal line GIO receives the data 1.

In related technologies, during a write operation, the global signal line GIO and the complementary global signal line GIO# transmit complementary data. Therefore, in an example embodiment of the present disclosure, a write driver circuit connected to the global signal line GIO and the complementary global signal line GIO# is further improved, so that the global signal line GIO and the complementary global signal line GIO# transmit the same data during the write operation.

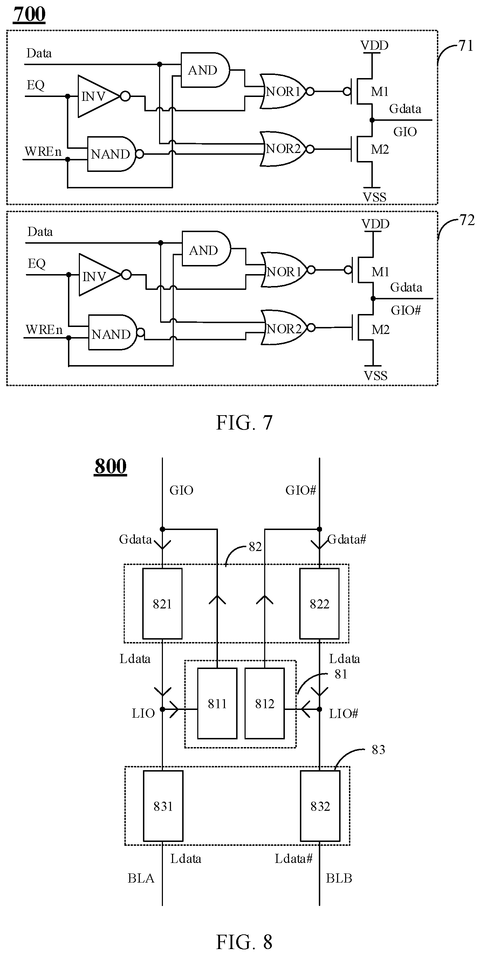

FIG. 7 is a schematic diagram of a write driver circuit according to an embodiment of the present disclosure.

Referring to FIG. 7, a write driver circuit 700 is connected to the read/write conversion circuit according to any one of the foregoing embodiments through the global signal line GIO and the complementary global signal line GIO#, and includes a first write driver unit 71 and a second write driver unit 72. Input terminals of the first write driver unit 71 and the second write driver unit 72 are configured to receive the same external input data Data. An output terminal of the first write driver unit 71 is connected to the global signal line GIO, an output terminal of the second write driver unit 72 is connected to the complementary global signal line GIO#, and output data Gdata of the first write driver unit 71 and the second write driver unit 72 is the same.

In the embodiment shown in FIG. 7, both the first write driver unit 71 and the second write driver unit 72 include an inverter INV, a NAND gate NAND, an AND gate AND, a first NOR gate NOR1, a second NOR gate NOR2, a first output transistor M1, and a second output transistor M2.

A first input terminal of the AND gate AND receives the external input data Data, and a second input terminal thereof receives a write enable signal WREn. An input terminal of the inverter INV receives an equalization signal EQ. Two input terminals of the first NOR gate NOR1 are respectively connected to an output terminal of the AND gate AND and an output terminal of the inverter INV. A first input terminal of the NAND gate NAND receives the equalization signal EQ, and a second input terminal thereof receives the write enable signal WREn. Two input terminals of the second NOR gate NOR2 are configured to receive the external input data Data and be connected to an output terminal of the NAND gate NAND, respectively. An output terminal of the first NOR gate NOR1 controls the first output transistor M1, and an output terminal of the second NOR gate NOR2 controls the second output transistor M2. The first output transistor M1 is a P-type transistor, with a source connected to the source voltage VDD and a drain connected to the global signal line GIO or the complementary global signal line GIO#. The second output transistor M2 is an N-type transistor, with a source grounded and a drain connected to the global signal line GIO or the complementary global signal line GIO#.

During a write operation, the write enable signal WREn is at a high level, and the equalization signal EQ is at a high level.

If the external input data Data is 1, the AND gate AND outputs the data 1, the first NOR gate NOR1 outputs the data 0, the first output transistor M1 is turned on, and the global signal line GIO and the complementary global signal line GIO# receive the data Gdata=1. In addition, the NAND gate NAND outputs the data 0, the second NOR gate NOR2 outputs the data 0, and the second output transistor M2 is turned off.

If the external input data Data is 0, the AND gate AND outputs the data 0, the first NOR gate NOR1 outputs the data 1, and the first output transistor M1 is turned off. The NAND gate NAND outputs the data 0, the second NOR gate NOR2 outputs the data 1, the second output transistor M2 is turned on, and the global signal line GIO and the complementary global signal line GIO# receive the data Gdata=0.

Because the first write driver unit 71 and the second write driver unit 72 have totally the same circuit structure, the first write driver unit 71 and the second write driver unit 72 receive the same external data, and output the same data Gdata to the global signal line GIO and the complementary global signal line GIO#.

The circuit shown in FIG. 7 is merely an example. In practice, as long as the circuit structures and functions of the first write driver unit 71 and the second write driver unit 72 are set to be the same, the first write driver unit 71 and the second write driver unit 72 can receive the same external data, and output the same data Gdata to the global signal line GIO and the complementary global signal line GIO#.

In another embodiment of the present disclosure, another read/write conversion circuit is provided.

FIG. 8 is a schematic diagram of another read/write conversion circuit according to an example embodiment of the present disclosure.

Referring to FIG. 8, a read/write conversion circuit 800 includes the following:
a second read circuit 81, including a first input terminal, a second input terminal, a first output terminal, and a second output terminal, the first input terminal and the second input terminal of the second read circuit 81 being respectively connected to a local signal line LIO and a complementary local signal line LIO#, and the first output terminal and the second output terminal of the second read circuit 81 being respectively connected to a global signal line GIO and a complementary global signal line GIO#;
a second write circuit 82, including a first input terminal, a second input terminal, a first output terminal, and a second output terminal, the first input terminal and the second input terminal of the second write circuit 82 being respectively connected to the global signal line GIO and the complementary global signal line GIO#, and the first output terminal and the second output terminal of the second write circuit 82 being respectively connected to the local signal line LIO and the complementary local signal line LIO#; and
a local read/write control circuit 83, including a first terminal, a second terminal, a third terminal, and a fourth terminal, the first terminal and the second terminal of the local read/write control circuit 83 being respectively connected to the local signal line LIO and the complementary local signal line LIO#, and the third terminal and the fourth terminal of the local read/write control circuit 83 being respectively connected to a bit line BLA and a complementary bit line BLB;
the first input terminal and the second input terminal of the second write circuit 82 receiving inverted data, and the first output terminal and the second output terminal of the second write circuit 82 outputting the same data; and the first terminal and the second terminal of the local read/write control circuit 83 receiving the same data, and the third terminal and the fourth terminal of the local read/write control circuit 83 outputting inverted data.

In the embodiment shown in FIG. 8, the second read circuit 81 includes a third read conversion module 811 and a fourth read conversion module 812, the third read conversion module 811 is connected between the global signal line GIO and the local signal line LIO, and is configured to transmit data on the local signal line LIO to the global signal line GIO. The fourth read conversion module 812 is connected between the complementary global signal line GIO# and the complementary local signal line LIO#, and is configured to transmit data on the complementary local signal line LIO# to the complementary global signal line GIO#.

The third read conversion module 811 and the fourth read conversion module 812 have the same structure. When data transmitted on the local signal line LIO and the complementary local signal line LIO# is different and inverted, data transmitted to the global signal line GIO and the complementary global signal line GIO# through the third read conversion module 811 and the fourth read conversion module 812 is also different and inverted.

The second read circuit 81 may have totally the same circuit structure as the first read circuit 11 in the embodiment shown in FIG. 2. No special limitation is imposed on the present disclosure.

The second write circuit 82 includes a third write conversion circuit 821 connected between the global signal line GIO and the local signal line LIO and a fourth write conversion circuit 822 connected between the complementary global signal line GIO# and the complementary local signal line LIO#, the third write conversion circuit 821 is configured to transmit data on the global signal line GIO to the local signal line LIO during a write operation, and the fourth write conversion circuit 822 is configured to transmit inverted data on the complementary global signal line GIO# to the complementary local signal line LIO# during a write operation. The third write conversion circuit 821 and the fourth write conversion circuit 822 receive different and inverted data, and output the same data.

The local read/write control circuit 83 includes a first read/write control circuit 831 connected between the local signal line LIO and the bit line BLA and a second read/write control circuit 832 connected between the complementary local signal line LIO# and the complementary bit line BLB, the first read/write control circuit 831 is configured to transmit inverted data on the local signal line LIO to the bit line BLA during a write operation, and transmit data on the bit line BLA to the local signal line LIO during a read operation; and the second read/write control circuit 832 is configured to transmit data on the complementary local signal line LIO# to the complementary bit line BLB during a write operation and transmit data on the complementary bit line BLB to the complementary local signal line LIO# during a read operation.

During a write operation, the first read/write control circuit 831 and the second read/write control circuit 832 receive the same data, and output different and inverted data. During a read operation, the first read/write control circuit 831 and the second read/write control circuit 832 receive different and inverted data, and output different and inverted data.

Transmitting the same data on the local signal line LIO and the complementary local signal line LIO# during a write operation helps increase a conversion speed for converting the write operation to a read operation.

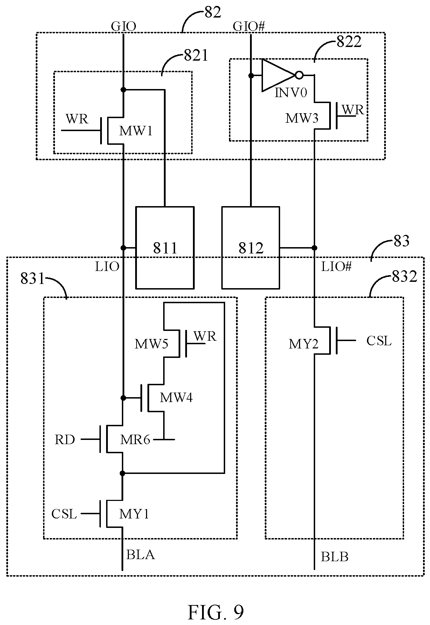

FIG. 9 is a circuit diagram of a read/write conversion circuit 800 according to an embodiment.

Referring to FIG. 9, in an embodiment, the third write conversion circuit 821 includes a first write transistor MW1. A first terminal of the first write transistor MW1 is connected to the global signal line GIO, a second terminal thereof is connected to the local signal line LIO, and a control terminal thereof receives a write control signal WR.

The fourth write conversion circuit 822 includes a data inverter INVO and a third write transistor MW3. An input terminal of the data inverter INVO is connected to the complementary global signal line GIO#, an output terminal thereof is connected to a first terminal of the third write transistor MW3, a second terminal of the third write transistor MW3 is connected to the complementary local signal line LIO#, and a control terminal thereof receives a write control signal WR. Alternatively, the inverter INVO may be replaced with another element or element combination capable of implementing a signal inverting function, for example, the foregoing second write transistor MW2. A person skilled in the art may autonomously perform settings according to an actual situation.

Both the first write transistor MW1 and the third write transistor MW3 are N-type transistors. During a write operation, the write control signal WR is at a high level, that is, in an enabled state, the local signal line LIO receives data on the global signal line GIO, and the complementary local signal line LIO# receives inverted data, of the data, on the complementary global signal line GIO#.

The first read/write control circuit 831 includes a sixth read transistor MR6, a fourth write transistor MW4, a fifth write transistor MW5, and a first column selection transistor MY1.

A first terminal of the sixth read transistor MR6 is connected to the local signal line LIO, a second terminal thereof is connected to a first terminal of the first column selection transistor MY1, and a control terminal thereof receives a read control signal RD. A gate of the fourth write transistor MW4 is connected to the local signal line LIO, a source thereof is grounded, and a drain thereof is connected to a second terminal of the fifth write transistor MW5. A first terminal of the fifth write transistor MW5 is connected to a first terminal of the first column selection transistor MY1, and a control terminal thereof receives a write control signal WR. A second terminal of the first column selection transistor MY1 is connected to the bit line BLA, and a control terminal thereof receives a column selection signal CSL.

The second read/write control circuit 832 includes a second column selection transistor MY2, a first terminal of the second column selection transistor MY2 is connected to the complementary local signal line LIO#, a second terminal thereof is connected to the complementary bit line BLB, and a control terminal thereof receives a column selection signal CSL.

During a write operation, the write control signal WR is at a high level, the read control signal RD is at a low level, the fifth write transistor MW5 is turned on, and the sixth read transistor MR6 is turned off. The first terminal of the first column selection transistor MY1 is set to be equal to a first equalization voltage or a bit line equalization voltage.

Data on the complementary global signal line GIO# is transmitted to the first terminal of the second column selection transistor MY2 through the inverter INVO and the turned-on third write transistor MW3, and data on the global signal line GIO is transmitted to the first terminal of the first column selection transistor MY1 through the turned-on first write transistor MW1, the fourth write transistor MW4, and the turned-on fifth write transistor MW5. A time sequence difference between the data received by the first column selection transistor MY1 and the data received by the second column selection transistor MY2 is relatively small. When the column selection signal CSL an enable signal, time points for receiving data by the bit line BLA and the complementary bit line BLB are close, and data receive quality is relatively high.

When both the local signal line LIO and the complementary local signal line LIO# transmit data 1, the fourth write transistor MW4 is turned on, the first terminal of the first column selection transistor MY1 receives data 0, and the first terminal of the second column selection transistor MY2 receives the data 1. When the column selection signal CS is an enable signal, the data 1 and the data 0 are transmitted to the bit line BLA and the complementary bit line BLB through the first column selection transistor MY1 and the second column selection transistor MY2, respectively.

When both the local signal line LIO and the complementary local signal line LIO# transmit the data 0, the fourth write transistor MW4 is turned off, the first terminal of the first column selection transistor MY1 is equal to the first equalization voltage or the bit line equalization voltage, and the first terminal of the second column selection transistor MY2 receives the data 0. When the column selection signal CSL is an enable signal, the first equalization voltage and the data 0 are transmitted to the bit line BLA and the complementary bit line BLB through the first column selection transistor MY1 and the second column selection transistor MY2, respectively. A sense amplifier connected to the bit line BLA and the complementary bit line BLB amplifies the voltage difference, so that a potential on the bit line BLA is set to a source voltage VDD and the data 1 is received on the bit line BLA.

During data reading, the write control signal WR is at a low level, the read control signal RD is at a high level, the fifth write transistor MW5 is turned off, and the sixth read transistor MR6 is turned on. When the column selection signal CSL is an enable signal, the first column selection transistor MY1 and the second column selection transistor MY2 are turned on, and the local signal line LIO and the complementary local signal line LIO# receive the data on the bit line BLA and the complementary bit line BLB through the turned-on first column selection transistor MY1 and the turned-on second column selection transistor MY2, respectively.

The circuit shown in FIG. 9 is merely an example. In another embodiment of the present disclosure, another circuit implementation may be alternatively provided to implement the second write circuit 82 and the local read/write control circuit 83.

In an example embodiment of the present disclosure, a memory is further provided, including the circuit according to any one of the foregoing embodiments.

It should be noted that, although several modules or units of a device for performing actions are mentioned in the foregoing detailed descriptions, such division is not mandatory. In practice, according to the implementations of the present disclosure, features and functions of two or more modules or units described above may be embodied in one module or unit. On the contrary, features and functions of one module or unit described above may be further divided into multiple modules or units to be embodied.

A person skilled in the art can easily figure out other implementation solutions of the present disclosure after considering the specification and practice of the present disclosure herein. This application is intended to cover any variations, functions, or adaptive changes of the present disclosure. These variations, functions, or adaptive changes comply with general principles of the present disclosure, and include common knowledge or a conventional technical means in the art that is not disclosed in the present disclosure. The specification and embodiments are merely considered to be exemplary, and the true scope and conception of the present disclosure are pointed out by the claims.

## Claims

1. A read/write conversion circuit (100), comprising:
a first read circuit (11), a first input terminal and a second input terminal of the first read circuit (11) being respectively connected to a local signal line (LIO) and a complementary local signal line (LIO#), and a first output terminal and a second output terminal of the first read circuit (11) being respectively connected to a global signal line (GIO) and a complementary global signal line (GIO#); and
a first write circuit (12), a first input terminal and a second input terminal of the first write circuit (12) being respectively connected to the global signal line (GIO) and the complementary global signal line (GIO#), and a first output terminal and a second output terminal of the first write circuit (12) being respectively connected to the local signal line (LIO) and the complementary local signal line (LIO#);
the first input terminal and the second input terminal of the first write circuit (12) receiving the same data, and the first output terminal and the second output terminal of the first write circuit (12) outputting inverted data.

2. The read/write conversion circuit (100) according to claim 1, wherein the first write circuit (12) comprises a first write conversion circuit (121) connected between the first input terminal and the first output terminal of the first write circuit (12) and a second write conversion circuit (122) connected between the second input terminal and the second output terminal of the first write circuit (12), the first write conversion circuit (121) is configured to transmit data from the global signal line (GIO) to the local signal line (LIO), and the second write conversion circuit (122) is configured to transmit inverted data, of the data, from the complementary global signal line (GIO#) to the complementary local signal line (LIO#).

3. The read/write conversion circuit (100) according to claim 2, wherein
the first write conversion circuit (121) comprises a first write transistor (MW1), a first terminal of the first write transistor (MW1) is connected to the global signal line (GIO), a second terminal of the first write transistor (MW1) is connected to the local signal line (LIO), and a control terminal of the first write transistor (MW1) receives a write control signal (WR);
the second write conversion circuit (122) comprises a second write transistor (MW2) and a third write transistor (MW3), a first terminal of the second write transistor (MW2) is grounded, a control terminal thereof is connected to the complementary global signal line (GIO#), a first terminal of the third write transistor (MW3) is connected to a second terminal of the second write transistor (MW2), a second terminal of the third write transistor (MW3) is connected to the complementary local signal line (LIO#), and a control terminal of the third write transistor (MW3) receives the write control signal (WR); and
the first write transistor (MW1), the second write transistor (MW2), and the third write transistor (MW3) are all N-type transistors.

4. The read/write conversion circuit (100) according to any one of claims 1 to 3, wherein the first read circuit (11) comprises a first read conversion circuit (111) connected between the first input terminal and the first output terminal of the first read circuit (11), a second read conversion circuit (112) connected between the second input terminal and the second output terminal of the first read circuit (11), and a voltage source circuit (113) connecting the first read conversion circuit (111) and the second read conversion circuit (112), the first read conversion circuit (111) and the second read conversion circuit (112) have the same structure, the first read circuit (11) is configured to transmit data from the local signal line (LIO) to the global signal line (GIO), and a second read circuit (81) is configured to transmit data from the complementary local signal line (LIO#) to the complementary global signal line (LIO#).

5. The read/write conversion circuit (100) according to claim 4, wherein the first read conversion circuit (111) comprises a first read transistor (MR1) and a second read transistor (MR2), a control terminal of the first read transistor (MR1) is connected to the local signal line (LIO), a first terminal of the first read transistor (MR1) is connected to the voltage source circuit (113), a control terminal of the second read transistor (MR2) receives a read control signal, a first terminal of the second read transistor (MR2) is connected to a second terminal of the first read transistor (MR1), and a second terminal of the second read transistor (MR2) is connected to the global signal line (GIO);
the second read conversion circuit (112) comprises a third read transistor (MR3) and a fourth read transistor (MR4), a control terminal of the third read transistor (MR3) is connected to the complementary local signal line (LIO#), a first terminal of the third read transistor (MR3) is connected to the voltage source circuit (113), a control terminal of the fourth read transistor (MR4) receives a read control signal, a first terminal of the fourth read transistor (MR4) is connected to a second terminal of the third read transistor (MR3), and a second terminal of the fourth read transistor (MR4) is connected to the complementary global signal line (GIO#); and
the first read transistor (MR1), the second read transistor (MR2), the third read transistor (MR3), and the fourth read transistor (MR4) are all N-type transistors.

6. A write driver circuit, connected to the read/write conversion circuit (100) according to any one of claims 1 to 5, comprising a first write driver unit (71) and a second write driver unit (72), input terminals of the first write driver unit (71) and the second write driver unit (72) being configured to receive the same external input data (Data), an output terminal of the first write driver unit (71) being connected to a global signal line (GIO), an output terminal of the second write driver unit (72) being connected to a complementary global signal line (GIO#), and output data of the first write driver unit (71) and the second write driver unit (72) being the same.

7. A read/write conversion circuit (100), comprising:
a second read circuit (81), comprising a first input terminal, a second input terminal, a first output terminal, and a second output terminal, the first input terminal and the second input terminal of the second read circuit (81) being respectively connected to a local signal line (LIO) and a complementary local signal line (LIO#), and the first output terminal and the second output terminal of the second read circuit (81) being respectively connected to a global signal line (GIO) and a complementary global signal line (GIO#);
a second write circuit (82), comprising a first input terminal, a second input terminal, a first output terminal, and a second output terminal, the first input terminal and the second input terminal of the second write circuit (82) being respectively connected to the global signal line (GIO) and the complementary global signal line (GIO#), and the first output terminal and the second output terminal of the second write circuit (82) being respectively connected to the local signal line (LIO) and the complementary local signal line (LIO#); and
a local read/write control circuit (83), comprising a first input terminal, a second input terminal, a first output terminal, and a second output terminal, the first input terminal and the second input terminal of the local read/write control circuit (83) being respectively connected to the local signal line (LIO) and the complementary local signal line (LIO#), and the first output terminal and the second output terminal of the local read/write control circuit (83) being respectively connected to a bit line (BLA) and a complementary bit line (BLB);
the first input terminal and the second input terminal of the second write circuit (82) receiving inverted data, and the first output terminal and the second output terminal of the second write circuit (82) outputting the same data; and the first input terminal and the second input terminal of the local read/write control circuit (83) receiving the same data, and the first output terminal and the second output terminal of the local read/write control circuit (83) outputting inverted data.

8. The read/write conversion circuit (100) according to claim 7, wherein the second read circuit (81) comprises a third read conversion module (811) and a fourth read conversion module (812), the third read conversion module (811) is connected between the global signal line (GIO) and the local signal line (LIO), and is configured to transmit data on the local signal line (LIO) to the global signal line (GIO); and the fourth read conversion module (812) is connected between the complementary global signal line (GIO#) and the complementary local signal line (LIO#), and is configured to transmit data on the complementary local signal line (LIO#) to the complementary global signal line (GIO#);
the second write circuit (82) comprises a third write conversion circuit (821) connected between the global signal line (GIO) and the local signal line (LIO) and a fourth write conversion circuit (822) connected between the complementary global signal line (GIO#) and the complementary local signal line (LIO#), the third write conversion circuit (821) is configured to transmit data on the global signal line (GIO) to the local signal line (LIO) during a write operation, and the fourth write conversion circuit (822) is configured to transmit data on the complementary global signal line (GIO#) to the complementary local signal line (LIO#) during a write operation; and
the local read/write control circuit (83) comprises a first read/write control circuit (831) connected between the local signal line (LIO) and the bit line (BLA) and a second read/write control circuit (832) connected between the complementary local signal line (LIO#) and the complementary bit line (BLB), the first read/write control circuit (831) is configured to transmit data on the local signal line (LIO) to the bit line (BLA) during a write operation, and transmit data on the bit line (BLA) to the local signal line (LIO) during a read operation; and the second read/write control circuit (832) is configured to transmit data on the complementary local signal line (LIO#) to the complementary bit line (BLB) during a write operation and transmit data on the complementary bit line (BLB) to the complementary local signal line (LIO#) during a read operation.

9. The read/write conversion circuit (100) according to claim 8, wherein the third write conversion circuit (821) comprises a first write transistor (MW1), a first terminal of the first write transistor (MW1) is connected to the global signal line (GIO), a second terminal thereof is connected to the local signal line (LIO), and a control terminal thereof receives a write control signal (WR); and
the fourth write conversion circuit (822) comprises a data inverter (INVO) and a third write transistor (MW3), an input terminal of the data inverter (INVO) is connected to the complementary global signal line (GIO#), an output terminal thereof is connected to a first terminal of the third write transistor (MW3), a second terminal of the third write transistor (MW3) is connected to the complementary local signal line (LIO#), and a control terminal thereof receives a write control signal (WR).

10. The read/write conversion circuit (100) according to claim 9, wherein the first read/write control circuit (831) comprises a sixth read transistor (MR6), a fourth write transistor (MW4), a fifth write transistor (MW5), and a first column selection transistor (MY1), a first terminal of the sixth read transistor (MR6) is connected to the local signal line (LIO), a second terminal thereof is connected to a first terminal of the first column selection transistor (MY1), and a control terminal thereof receives a read control signal (Rd); a gate of the fourth write transistor (MW4) is connected to the local signal line (LIO), a source thereof is grounded, and a drain thereof is connected to a second terminal of the fifth write transistor (MW5); a first terminal of the fifth write transistor (MW5) is connected to the first terminal of the first column selection transistor (MY1), and a control terminal thereof receives a write control signal (WR); and a second terminal of the first column selection transistor (MY1) is connected to the bit line (BLA), and a control terminal thereof receives a column selection signal (CSL); and
the second read/write control circuit (832) comprises a second column selection transistor (MY2), a first terminal of the second column selection transistor (MY2) is connected to the complementary local signal line (LIO#), a second terminal thereof is connected to the complementary bit line (BLB), and a control terminal thereof receives a column selection signal (CSL).
